# EUROPEAN PATENT SPECIFICATION

(11) **EP 2 420 593 B1**
(45) Date of publication and mention of the grant of the patent: **03.04.2013**
(21) Application number: 11173897.7
(22) Date of filing: 14.07.2011
(51) Int. Cl.: C23C 18/20, H05K 3/42, C23C 18/32, C23C 18/38, H05K 3/38, H05K 3/46, C25D 5/12, C25D 5/56, H05K 3/18

(54) **Metalized Plastic Articles and Methods Thereof**
Metallisierte Kunststoffartikel und Verfahren dafür
Articles plastiques métallisés et procédés associés

(30) Priority: 19.08.2010 CN 201010260236
(43) Date of publication of application: 22.02.2012
(73) Proprietor: BYD Company Limited, Shenzhen 518118 (CN)
(72) Inventor: GONG, Qing, 518118 Shenzhen, (CN); ZHOU, Liang, 518118 Shenzhen (CN); MIAO, Weifeng, 518118 Shenzhen (CN); ZHANG, Xiong, 518118 Shenzhen (CN)
(74) Representative: Gulde Hengelhaupt Ziebig & Schneider

(56) References cited:
- EP-A1- 1 650 249
- US-A- 3 546 011
- US-A- 4 767 665
- US-A- 5 162 144

## Description

The present disclosure relates generally to plastic articles and a manufacturing method thereof. In more particularity, the present disclosure relates to a surface metallization method for the plastic article.

### BACKGROUND OF THE PRESENT DISCLOSURE

Plastic substrates having a metalized layer on their surfaces as pathways of electromagnetic signal conduction are widely used in automobiles, industries, computers and telecommunications etc. Selectively forming a metalized layer is one of the important processes for preparing such plastic products. The method for forming a metalized layer in prior art is usually practiced by forming a metal core as a catalytic center on the plastic support surface so that chemical plating may be performed. However, processes related thereto are complex where strict demand on equipment is needed whereas the energy consumption is high. Further, there is a low adhesive force between the coating and the plastic support.

One example in US patent No. US2003031803A1 discloses a process for metalizing a substrate part, including the following three steps: coating said part with a precursor composite material layer consisting of a polymer matrix doped with photoreducer material dielectric particles, irradiating the surface to be metalized of said substrate part with a light beam emitted by a laser, immersing the irradiated part in an autocatalytic bath containing metal ions, with deposition of the latter in a layer on the irradiated surface, and wherein the dimension of said dielectric particles is less than or equal to 0.5 microns. Another example in US patent No. US7060421 discloses a method of producing a conductor track structure on a non-conductive support comprising: providing a non-conductive support having at least a surface formed of a non-conductive supporting material having at least one thermally stable, spinel-based, non-conductive metal oxide which is stable and insoluble in aqueous acid or alkaline metallization baths dispersed therein; irradiating areas of said support on which conductive tracks are to be formed with electromagnetic radiation to break down the non-conductive metal oxides and release metal nuclei, and subsequently metalizing the irradiated areas by chemical reduction.

### SUMMARY OF THE DISCLOSURE

According to one aspect of the present invention, there is provided a method of manufacturing a plastic article with a metalized surface composed of a plurality of metal layers comprising the steps of:
providing a plastic substrate made of a plastic material, in which a plurality of accelerator particles are dispersed, the accelerator particles being made of a compound selected from the group consisting of: CuFe₂0₄-δ, Ca_{0.25}Cu_{0.75}TiO_{3-β}, and Ti0_{2-σ}, wherein δ, β, σ is deemed to be 0.05≤δ≤0.8, 0.05≤β≤0.5, and 0.05≤σ≤1.0;
removing plastic material in a determined area of a surface of the plastic substrate; and
plating the exposed surface of the plastic substrate to form a first metal layer; plating the first metal layer to form a second metal layer.

Optionally, further metal layers may be subsequently plated.

According to another aspect of the present invention, there is provided a plastic substrate being made of a plastic material, in which a plurality of accelerator particles are dispersed, the accelerator particles being made of a compound selected from the group consisting of: CuFe₂O_{4-δ}, Ca_{0.25}Cu_{0.75}TiO_{3-β}, and TiO_{2-σ}, wherein δ, β σ is deemed to be 0.05≤δ≤0.8, 0.05≤β≤0.5, and 0.05≤σ≤1.0; and a metalized surface directly disposed on the plastic substrate and being composed of a plurality of metal layers.

Another aspect of the present invention refers to a plastic substrate being made of a plastic material, in which a plurality of accelerator particles are dispersed, the accelerator particles being made of a compound selected from the group consisting of: CuFe₂O_{4-δ}, Ca_{0.25}Cu_{0.75}TiO_{3-β}, and TiO_{2-σ}, wherein δ, β , σ is deemed to be 0.05≤δ≤0.8, 0.05≤β≤0.5, and 0.05≤σ≤1.0.

Further embodiments of the invention could be learned from the claims and the following description of the invention.

### DETAILED DISCRIPTION OF THE EMBODIMENT

In the following, a new method of manufacturing a plastic article with a metalized surface is disclosed. Thereby, a plastic article is provided having a metalized surface, which is directly disposed on the plastic substrate and being composed of a plurality of metal layers. Further, a substrate useful for the manufacturing method is disclosed.

### Accelerator particles

The accelerator particles are selected from the group consisting of: CuFe₂O_{4-δ}, Ca_{0.25}Cu_{0.75}TiO_{3-β}, and TiO_{2-σ}, and δ, β, σ is deemed to be 0.05≤δ≤0.8, 0.05≤β≤0.5, and 0.05≤σ≤1.0

The average diameter of each accelerator particle may range from 20 nanometers to 100 microns, alternatively from 50 nanometers to 10 microns, and alternatively from 200 nanometers to 4 microns. The accelerator particles may be from 1 wt% to 40 wt% of the total weight of the plastic substrate, alternatively from 1 wt% to 30 wt%, and alternatively from 2 wt% to 15 wt%.

Particularly suitable accelerators may include: CuFe₂O_{3.65}, CuFe₂O_{3.2}, Ca_{0.25}CU_{0.75}TiO_{2.84}, Ca_{0.25}Cu_{0.75}TiO_{2.5}, TiO, and TiO_{1.9}. Still further suitable accelerators, may include CuFe₂O₃.₆₅, Ca_{0.25}CU_{0.75}TiO_{2.84}, and TiO.

The accelerator particles may be commercially provided, or prepared by any technique known to those skilled in the art. For example, suitable methods for preparing the accelerator particle may include steps of: preparing metal oxides/composite metal oxides by any technique known to those skilled in the art, such as co-precipitation, sol-gel, hydrothermal process, solid state sintering, etc., or commercially provided; and calcining the metal oxides/composite metal oxides at high temperature in the presence of hydrogen of inert gases to form oxygen vacancies thereof to obtain the accelerator particle.

Methods of preparing suitable accelerator particles are generally known. A method for preparing CuFe₂O_{4-δ} may comprise the steps of: adding a mixture of Cu(NO₃)₂ and Fe(NO₃)₃ into a stirring potassium hydroxide solution by a peristaltic pump with a speed of 1 milliliter per minutes; heating the solution to a temperature of 80 °C and keep stirring for 24 hours, PH value of the solution maintaining at 10 to 11 while stirring; cleaning precipitates in the solution with distilled water and acetone and penetrating the precipitates; dry the penetrated precipitates at a temperature of 120 °C for 24 hours and granulating to 300 meshes to form a first end product; calcining the first end product at temperature of 1000 °C for a time of 4-6 hours in the presence of high purity nitrogen to form CuFe₂O_{4-δ} (0.05≤δ≤0.8).

Similarly, a method for preparing Ca_{0.25}Cu_{0.75}TiO_{3-β} may comprise similar steps. A method for preparing TiO_{2-σ} may comprise calcining nano titanium dioxide in the presence of nitrogen or reduce with reduction materials (such as NH₃, H₂, and Mg) to remove oxygen in the titanium dioxide. The nano titanium dioxide may be commercially available.

The accelerator may be commercially provided. In an embodiment, the accelerator particle may be titanium black (Tilack provided from Akoh Kasei, Japan), or titanium black (Tilox fromBo Kwang, Korea).

The accelerator particles are used directly as chemical catalyst for plating. Plating on the accelerators thus not cause plastic degradation.

The accelerator particles may be uniformly dispersed within the plastic. Uniform dispersion of the accelerator particle in the plastic aids in forming a strong adhesion between the metal layer and the plastic substrate. The power applied may be sufficient to remove plastic materials in the determined area and expose at least a first accelerator particle, no extra high power is needed to reduce the accelerator particles to pure metals. Copper plating or nickel plating then may be performed on the exposed accelerator particles. The method has low requirement on energy, has low production cost, and be simple to perform.

The accelerator particle is a metal oxide or a metal composite oxide having oxygen vacancies. The metal oxide or metal composite oxide having oxygen vacancies may have strong reducibility and instability. For example, the accelerator particle CuFe₂Oₓ (x<4) has strong reducibility and instability due to: a) CuFe₂Oₓ(x<4) has oxygen vacancies and oxygen may be efficiently combined to crystal lattice of CuFe₂Oₓ(x<4); b) In CuFe₂Oₓ(x<4), electron transfer may exist not only between Cu⁺ and Cu²⁺, Fe²⁺ and Fe³⁺, but also between Cu⁺ and Fe³⁺, electron transfer may cause the lost of electrons which indicates a strong reducibility; c) During the period of forming oxygen vacancies in CuFe₂O₄, a large amount of cations may be combined in the crystalline lattice thereof, causing a extension of crystalline lattice gap, change of crystalline lattice, and the increasing of chemical potential energy. Therefore, CuFe₂Oₓ(x<4) with oxygen vacancies may have very instable structure and oxygen ions may be needed to fill the oxygen vacancies, which may form a strong reducibility.

According to various embodiments of the present disclosure, the metal oxide or metal composite oxide with a certain range of oxygen vacancies may be used as accelerator particles, and metal layers may be plated directly on the accelerator particles.

### Plastic material

The plastic material may be a thermoplastic plastic, or thermoset otherwise called a thermosetting plastic. The thermoplastic plastic may be selected from the group consisting of polyolefin, polyester, polyamide, polyaromatic ether, polyester-imide, polycarbonate (PC), polycarbonate/acrylonitrile-butadiene-styrene composite (PC/ABS), polyphenylene oxide (PPO), polyphenylene sulfide (PPS), polyimide (PI), polysulfone (PSU), poly (ether ether ketone) (PEEK), polybenzimidazole (PBI), liquid crystalline polymer (LCP), and combinations thereof. The polyolefin may be polystyrene (PS), polypropylene (PP), polymethyl methacrylate(PMMA) or acrylonitrile-butadiene-styrene (ABS); the polyester may be polycyclohexylene dimethylene terephthalate (PCT), poly(diallyl isophthalate) (PDAIP), poly(diallyl terephthalate) (PDAP), polybutylene naphthalate (PBN), Poly(ethylene terephthalate) (PET), or polybutylene terephthalate (PBT); the polyamide may be polyhexamethylene adipamide (PA-66), Nylon 69 (PA-69), Nylon 64 (PA-64), Nylon 612 (PA-612), polyhexamephylene sebacamide (PA-610), Nylon 1010 (PA-1010), Nylon 11 (PA-11), Nylon 12 (PA-12), Nylon 8 (PA-8), Nylon 9 (PA-9), polycaprolactam (PA-6), poly(p-phenytene terephthalamide) (PPTA), poly-meta-xylylene adipamide (MXD6), polyhexamethylene terephthalamide (PA6T), and Nylon 9T (PA9T). The thermoset may be one or more members selected from the group consisting of phenolic resin, urea-formaldehyde resin, melamine-formaldehyde resin, epoxy resin, alkyd resin, polyurethane, and combinations thereof.

### Dispersion of Accelerator(s) in Plastic

The accelerator particles are dispersed within the plastic material by any method of mixture or combination, followed, without limitation, by a molding process. In various embodiments, the accelerator particles may become dispersed in the plastic by using an internal mixer, a singer screw extruder, a twin screw extruder or a mixer. Then, a plastic substrate may be formed with various kinds of shapes during an injection molding, blow molding, extraction molding, or hot press molding processes.

### Additives

The plastic substrate may further comprise one or more generally known, and commercially available, additives selected from the group consisting of: an antioxidant; a light stabilizer; a lubricant; and inorganic fillers.

The antioxidant may be antioxidant 1098, 1076, 1010, 168 available from CIBA Holding Inc., located in Switzerland. The antioxidant may be about 0.01 wt% to about 2 wt% of the plastic substrate.

The light stabilizer may be any such commercially available product, including a hindered amine light stabilizer, such as light stabilizer 944 available from CIBA Holding Inc., located in Switzerland. The light stabilizer may be about 0.01 wt% to about 2 wt% of the plastic substrate.

The lubricant may be selected from the group consisting of: methylpolysiloxanes; EVA waxes formed from ethylene and vinyl acetate; polyethylene waxes; stearates; and combinations thereof. The lubricant may be about 0.01 wt% to about 2 wt% of the plastic substrate.

The inorganic filler may be talcum powders, calcium carbonates, glass fibers, calcium silicate fibers, tin oxides, or carbon blacks. Glass fibers may increase the depth of exposed determined area favoring copper adhesion in further copper plating step; and tin oxide or carbon black may improve removing speed of the plastic during the removing step to shorten the process period. In further embodiments, the inorganic filler may further be selected from the group consisting of glass beads, calcium sulfates, barium sulfates, titanium dioxides, pearl powders, wollastonites, diatomites, kaolins, pulverized coals, pottery clays, micas, oil shale ashes, aluminosilicates, aluminas, carbon fibers, silicon dioxides, zinc oxides, and combinations thereof, particularly those without harmful elements (Cr, etc) to the environment and human health. The inorganic filler may be about 1 wt% to about 70 wt% of the plastic substrate.

### Plastic Removing

Plastic material in a determined area of a surface of the plastic substrate is removed to expose the accelerator particle(s). The removing of plastic material in the determined area may be achieved by any know method in the art. In an embodiment, the determined area may be the entire surface of the plastic substrate, optionally plastic material in the determined area removed by laser irradiating, corona discharge, chemical corrosion, and grinding, to expose the accelerator particles. In an alternative embodiment, the determined area may be a part of a surface of the plastic substrate, optionally plastic material in the determined area removed by laser irradiating or corona discharge.

The determined area of the plastic substrate may be irradiated by laser or corona discharge, causing plastic evaporation and forming a diagram in this determined area. In this way, a diagram may be formed on a surface of the plastic substrate, and accelerator particles in the diagram area may be exposed.

The laser instrument may be an infrared laser, or an ultraviolet laser, such as a CO₂ laser marking system. The laser may have a wavelength ranging from about 157 nanometers to about 10.6 microns; a scanning speed of about 500 millimeters per second to about 8000 millimeters per second; a scanning step of about 3 microns to about 9 microns; a delaying time of about 30 microseconds to about 100 microseconds; a frequency of about 30 kilohertz to about 40 kilohertz; a power of about 3 watt to about 4 watt; and a filling space of about 10 microns to about 50 microns.

The corona discharge instrument may be a CW1003 corona discharge instrument provided by Sanxin Electronics Co., Ltd, Nantong, China. The corona discharge instrument may have a power more than zero to 3 kilowatt and a speed of 1 meter per minutes to 20 meters per minute.

The power of the laser or corona discharge instrument may be sufficiently great to expose at least one accelerator particle, and alternatively a plurality of accelerator particles, but not so strong as to alter or damage the accelerator particles, or reduce the accelerator particles to metals.

Optionally, chemical corrosion is applied to remove the entire surface of the plastic substrate. The chemical corrosion is performed by a corrosion bath of N,N-dimethylformamide or tetrahydrofuran for a corrosion time of 5 minutes to 60 minutes.

Optionally, grinding is applied to remove the entire surface of the plastic substrate. The grinding is performed by a metallurgical sandpaper and exposed surface of the plastic substrate has a depth ranging from10 microns to 50 microns.

The plastic substrate may have a thickness of about 500 microns, or more, and the depth of the exposed portion of the plastic substrate may range from about hundreds of nanometers to less than 100 microns. The determined area may have convexes and concaves in micro-structures, and copper may be filled in these micro-structures in the subsequent copper plating and forming strong adhesion between the substrate and the copper layer. In an embodiment, the areas without accelerators are not irradiated, and, those areas may have low deposition speed and poor adhesion. While, a few metals may deposit in these areas they may be easily removed by, for example and without limitation, ultrasonic cleaning. In this manner, the metalization may be controlled in required areas in the surface of the plastic substrate.

### First Plating

After removing plastic material in determined area of the plastic substrate a copper or nickel plating is performed.

After plastic removing, the accelerator particles are exposed in the determined areas. Thereafter, copper-plating or nickel-plating may be applied to the accelerator particles. The copper-plating and nickel-plating are generally known to those of ordinary skill in the art, and may include contacting the exposed plastic substrate with a copper-plating or a nickel-plating bath (described below). Without wishing to be bound by the theory, applicant believes that the exposed accelerator particles may favor the copper or nickel ions, to be reduced to copper or nickel powders, which may cover the surface of the exposed accelerator particles, and form a dense copper layer or nickel layer rapidly on the accelerator particles.

### Further Plating

Following the first plating, one or more chemical, or electroplating, layers may be applied to the copper layer or nickel layer. For example, after a first nickel layer, a copper layer may be chemical plated on the first nickel layer and then a second nickel layer may be chemically plated on the copper layer to form a composite plastic article, having a surface layer structure of Ni-Cu-Ni. Alternatively, an aurum layer may be flash layered, or plated, on the composite plastic article to form a plastic article having a layer structure of Ni-Cu-Ni-Au. In a further illustrative embodiment, after a first copper layer, a nickel layer, may be plated on the first copper layer, to form a composite plastic article, having a surface layer structure of Cu-Ni. Alternatively, an aurum layer may be flash layered, or plated, on the composite plastic article to form a plastic article having a layer structure of Cu-Ni-Au.

The nickel layer, or plate, may have a thickness ranging from 0.1 microns to 50 microns, alternatively from 1 micron to 10 microns, and alternatively from 2 microns to 3 microns. The copper layer, or plate, may have a thickness ranging from about 0.1 microns to about 100 microns, alternatively from about 1 microns to about 50 microns, and alternatively from about 5 microns to about 30 microns. The aurum layer may have a thickness ranging from about 0.01 microns to about 10 microns, alternatively from about 0.01 microns to about 2 microns, and alternatively from about 0.1 microns to about 1 microns. Chemical plating baths, electric solutions, and flash plating baths are generally known to those with ordinary skill in the art. The chemical plating bath for copper plating may comprise a copper salt and a reducer, with a pH value ranging from about 12 to about 13, wherein the reducer may reduce the copper ion to copper. The reducer may be selected from the group consisting of glyoxylic acids, hydrazines, sodium hypophosphites, and combinations thereof. In another embodiment, the chemical plating bath for copper plating may comprise 0.12 moles per liter ("mol/L") CuSO₄·5H₂O, 0.14 mol/L Na₂EDTA·2H₂O, 10 mol/L potassium ferrocyanide, 10 mg/L (milligram per liter) potassium ferrocyanide, 10 mg/L 2,2' bipyridine, and about 0.10 mol/L of glyoxylic acid (HCOCOOH), the bath having a pH of about 12.5 to about 13 adjusted by NaOH and H₂SO₄ solutions. The copper plating time may range from about 10 minutes to about 240 minutes. The chemical plating bath for nickel plating may comprise 23 grams per liter ("g/L") nickel sulfate, 18 g/L inferior sodium phosphate, 20 g/L lactic acid, 15 g/L malic acid, the bath having a pH of about 5.2 adjusted by a NaOH solution, and a temperature of about 85°C to about 90°C. The nickel plating time may range from about 8 minutes to about 15 minutes.

Aurum flash plating is generally known to those with ordinary skill in the art. The flash plating bath may be a BG-24 neutral aurum bath, which is commercially available from Shenzhen Jingyanchuang Chemical Company, located in Shenzhen, China.

The following examples provide additional details of some embodiments of the present disclosure:

### EXAMPLE 1

In the first example:
a) A mixture of Cu(NO₃)₂(0.5mol/L) and Fe(NO₃)₃(0.5mol/L) was added into a stirring potassium hydroxide solution by a peristaltic pump with a speed of 1 milliliter per minutes. The mixed solution was heated to a temperature of 80°C and maintained stirring for 24 hours, PH value of the solution kept at 10 to 11 while stirring. The precipitates in the solution were cleaned with distilled water and acetone, then the precipitated. Finally, the penetrated precipitates were dried at a temperature of 120°C for 24 hours and granulated to 300 meshes to form a first end product;
b) The first end product was calcined at temperature of 1000°C for a time of 4 hours in the presence of high purity nitrogen, then granulated for a time of 10 hours to form CuFe₂O_{4-δ} (0.05≤δ≤0.8) with an average diameter of 700 nanometers. The CuFe₂O_{4-δ} was chemically analyzed and results showed that δ =0.35;
c) PC/ABS resin alloy, CuFe₂O_{4-δ}(δ=0.35) powders, calcium silicate fiber, and antioxidant 1010 were mixed in a weight ratio of 100:10:30:0.2 in a high speed mixer to prepare a mixture; the mixture was then granulated in a twin screw extruder (provided from Nanjing Rubber & Plastics Machinery Plant Co., Ltd.) and then injection molded to form an plastic substrate for a circuit board of an LED lighting;
d) A metal circuit diagram was curved in a determined area of a surface of the plastic substrate with a DPF-M12 infrared laser, available from TIDE PHARMACEUTICAL CO., LTD, located in Beijing, China. The laser had a wavelength of 1064 nanometers, a scanning speed of 4000 millimeters per second, a step of 9 microns, a delaying time of 30 microseconds, a frequency of about 40 kilohertz, a power of 3 watt, and a filling space of 50 microns; the surface of the plastic article was then ultrasonically cleaned;
e) The plastic substrate was immersed in a nickel plating bath for 10 minutes to form a nickel layer having a thickness of 4 microns on the accelerators; the plastic substrate was immersed in a copper plating bath for 4 hours to form a copper layer having a thickness of 15 microns on the nickel layer; thereafter, the plastic substrate was immersed in a nickel plating bath for 10 minutes to form a nickel layer having a thickness of 5 microns on the copper layer; then the plastic substrate was flash plated with an aurum layer having a thickness of 0.03 microns on the nickel layer; where the copper plating bath comprised 0.12 mol/L C_{U}SO₄. ·5H₂O, 0.14 mol/L Na₂EDTA·2H₂O, 10 mg/L potassium ferrocyanide, 10 mg/L 2,2' bipyridine, 0.10 mol/L glyoxylic acid, having a pH of from 12.5 to 13, which was adjusted by NaOH and H₂SO4 solutions; the nickel plating bath comprised 23 g/L nickel sulfate, 18 g/L inferior sodium phosphate, 20 g/L lactic acid, 15 g/L malic acid, the bath had a PH value of about 5.2; the flash plating bath was BG-24 neutral aurum bath, which was obtained from SHENZHEN JINGYANCHUANG CHEMICAL COMPANY, located in Shenzhen, China; the plastic substrate was formed into a plastic article for a circuit board.

### EXAMPLE 2

In the second example:
a) A mixture of CaCO₃, CuO, and TiO₂ powders were evenly mixed according to stoichiometric ratio of Ca_{0.25}Cu_{0.75}TiO₃ then milled in a ball mill for a milling time of 8 hours, with absolute alcohol as the milling mediate. The milled mixture was pre-calcined at a temperature of 800°C for a time of 10 hours to form Ca_{0.25}Cu_{0.75}TiO₃ powders.
b) The Ca_{0.25}Cu_{0.75}TiO₃ powders were calcined at temperature of 900°C for a time of 4 hours in the presence of argon, then granulated to form Ca_{0.25}Cu_{0.75}TiO_{3-β} with an average diameter of 500 nanometers. The Ca₀.₂₅Cu_{0.75}TiO_{3-β} was chemically analyzed and results showed that β=0.16.
c) PP resin, Ca_{0.25}Cu_{0.75}TiO_{3-β}(β=0.16) powders, antioxidant 1010, and polyethylene wax were mixed in a weight ratio of 100:10:0.2:0.1 to prepare a mixture; the mixture was granulated then injection molded to form an plastic substrate for a shell of an electric connector.
d) A metal circuit diagram was curved in a determined area of a surface of the plastic substrate with a CW1003 corona discharge instrument commercially available from Sanxin Electronics Co., Ltd, located in Nantong, China. The instrument had a speed of 1 meter per minute and a power of 2 kilowatt.
e) The plating step was in the same manner as in step (e) of EXAMPLE 1, with the following exceptions: the plastic substrate was immersed in a nickel plating bath for 8 minutes to form a nickel layer having a thickness of 2 microns on the accelerators; the plastic substrate was immersed in a copper plating bath for 4 hours to form a copper layer having a thickness of 15 microns on the nickel layer; thereafter, the plastic substrate was immersed in a nickel plating bath for 10 minutes to form a nickel layer having a thickness of 3 microns on the copper layer; then the plastic substrate was flash plated with an aurum layer having a thickness of 0.03 microns on the nickel layer.

### EXAMPLE 3

In the third example, the plastic article was prepared in the same manner as in EXAMPLE 1, with the following exceptions:
In step c) titanium black (average diameter of 50 nanometers, TiO_{2-σ}, σ=1, Tilack, commercially from Akoh Kasei Company, located in Japan), PP resin, calcium silicate fiber, and antioxidant 1010 were mixed in a weight ratio of 100:10:30:0.2 in a high speed mixer to prepare a mixture; the mixture was then granulated in a twin screw extruder (provided from Nanjing Rubber & Plastics Machinery Plant Co., Ltd.) and then injection molded to form an plastic substrate for a circuit board of an LED lighting;
In step d) the metal circuit diagram was curved in a determined area of a surface of the plastic substrate by chemical corrosion, with a corrosion material of N,N-dimethylformamide and a corrosion time of 30 minutes.

### EXAMPLE 4

In the fourth example, the plastic article was prepared in the same manner as in EXAMPLE 2, with the following exceptions:
In step c) the mixture was granulated then injection molded to form an plastic substrate for a component of bath equipments; and
In step d) all the surface of the plastic substrate was polished by a metallurgical sandpaper, and exposed portion of the plastic substrate had a depth of 20 microns.

## Claims

1. A method of manufacturing a plastic article with a metalized surface composed of a plurality of metal layers comprising the steps of:
providing a plastic substrate made of a plastic material, in which a plurality of accelerator particles are dispersed, the accelerator particles being made of a compound selected from the group consisting of: CuFe₂O_{4-δ}, Ca_{0.25}Cu_{0.75}TiO_{3-β}, and TiO_{2-σ}, wherein δ, β, σ is deemed to be 0.05≤δ≤0.8, 0.05≤β≤0.5, and 0.05≤σ≤1.0;
removing plastic material in a determined area of a surface of the plastic substrate;
plating the exposed surface of the plastic substrate to form a first metal layer;
plating the first metal layer to form a second metal layer; and
optionally, subsequent plating of further metal layers.

2. The method of claim 1, wherein the accelerator is evenly distributed throughout the plastic substrate.

3. The method of any one of the preceding claims, wherein plastic material in the determined area is removed by a process selected from a group consisting of laser irradiating, corona discharge, chemical corrosion, and grinding.

4. The method of any one of the preceding claims, wherein the second metal layer is electroplated or chemical plated.

5. The method of any one of the preceding claims, wherein the metal layers are made of a metal selected from the group consisting of nickel, copper and aurum.

6. The method of claim 5, wherein the first metal layer consists of nickel or copper.

7. The method of claim 6, wherein the metal surface of the plastic article consists of sequentially plated metal layers having a structure selected from the group consisting of Ni-Cu-Ni; Ni-Cu-Ni-Au; Cu-Ni; and Cu-Ni-Au.

8. The method of claim 7, wherein the nickel layers each have a thickness ranging from 0.1 microns to 50 microns; the copper layers each have a thickness ranging from 0.1 microns to 100 microns; and the aurum layers each have a thickness ranging from 0.01 microns to 10 microns.

9. The method of any one of the preceding claims, wherein the accelerator particles have an average diameter ranging from 20 nanometers to 100 microns.

10. The method of any one of the preceding claims, wherein the amount of accelerator particles is 1 wt% to 40 wt% of the total weight of the plastic substrate.

11. The method of any one of the preceding claims, wherein the accelerator particles are made of a compound selected from the group consisting of: CuFe₂O_{3.65}, Ca_{0.25}Cu_{0.75}TiO_{2.84}, and TiO.

12. The method of any one of the preceding claims, wherein the plastic material is selected from group consisting of a thermoplastic and a thermoset.

13. The method of claim 12, wherein- the thermoplastic plastic is selected from the group consisting of polyolefin, polycarbonate (PC), polyester, polyamide, polyaromatic ether, polyester-imide, polycarbonate/acrylonitrile-butadiene-styrene composite (PC/ABS), polyphenylene oxide (PPO), polyphenylene sulfide (PPS), polyimide (PI), polysulfone (PSU), poly (ether ether ketone) (PEEK), polybenzimidazole (PBI), liquid crystalline polymer (LCP), and combinations thereof; and the thermoset is selected from the group consisting of: phenolic resin, urea-formaldehyde resin, melamine-formaldehyde resin, epoxy resin, alkyd resin, polyurethane, and combinations thereof.

14. A plastic article comprising:
a plastic substrate being made of a plastic material, in which a plurality of accelerator particles are dispersed, the accelerator particles being made of a compound selected from the group consisting of: CuFe₂O_{4-δ}, Ca_{0.25}Cu_{0.75}TiO_{3-β}, and TiO_{2-σ}, wherein δ, β, σ is deemed to be 0.05≤δ≤0.8, 0.05≤β≤0.5, and 0.05≤σ≤1.0; and
a metalized surface directly disposed on the plastic substrate and being composed of a plurality of metal layers.

15. A plastic substrate being made of a plastic material, in which a plurality of accelerator particles are dispersed, the accelerator particles being made of a compound selected from the group consisting of: CuFe₂O_{4-δ}, Ca_{0.25}Cu_{0.75}TiO_{3-β}, and TiO_{2-σ}, wherein δ, β, σ is deemed to be 0.05≤δ≤0.8, 0.05≤β≤0.5, and 0.05≤σ≤1.0

## Patentansprüche

1. Verfahren zur Herstellung eines Kunststoffartikels mit einer metallisierten Oberfläche, der aus einer Vielzahl von Metallschichten zusammengesetzt ist, wobei das Verfahren die folgenden Schritte aufweist:
Bereitstellen eines Kunststoffsubstrats, das aus einem Kunststoffmaterial hergestellt ist, in dem eine Vielzahl von Beschleunigerteilchen dispergiert ist, wobei die Beschleunigerteilchen aus einer Verbindung hergestellt sind, die aus der Gruppe bestehend aus CuFe₂O_{4-δ}, Ca_{0.25}Cu_{0,75}TiO_{3-β} und TiO_{2-σ} ausgewählt ist, wobei für δ, β, σ gilt: 0,05≤δ≤0,8, 0,05≤ß≤0,5 und 0,05≤σ≤1,0;
Entfernen des Kunststoffmaterials in einem bestimmten Bereich einer Oberfläche des Kunststoffsubstrats;
Plattieren der freigelegten Oberfläche des Kunststoffsubstrats zum Ausbilden einer ersten Metallschicht;
Plattieren der ersten Metallschicht zum Ausbilden einer zweiten Metallschicht; und
optional nachfolgendes Plattieren weiterer Metallschichten.

2. Verfahren nach Anspruch 1, wobei der Beschleuniger gleichmäßig über das gesamte Kunststoffsubstrat verteilt ist.

3. Verfahren nach einem der vorhergehenden Ansprüche, wobei Kunststoffmaterial in dem bestimmten Bereich durch ein Verfahren entfernt wird, das aus einer Gruppe bestehend aus Laserbestrahlung, Koronaentladung, chemischer Korrosion und Schleifen ausgewählt ist.

4. Verfahren nach einem der vorhergehenden Ansprüche, wobei die zweite Metallschicht galvanisiert oder chemisch plattiert wird.

5. Verfahren nach einem der vorhergehenden Ansprüche, wobei die Metallschichten aus einem Metall hergestellt sind, das aus der Gruppe bestehend aus Nickel, Kupfer und Gold ausgewählt ist.

6. Verfahren nach Anspruch 5, wobei die erste Metallschicht aus Nickel oder Kupfer besteht.

7. Verfahren nach Anspruch 6, wobei die Metallfläche des Kunststoffartikels aus aufeinanderfolgend plattieren Metallschichten besteht, die eine Struktur aufweisen, die aus der Gruppe bestehend aus Ni-Cu-Ni, Ni-Cu-Ni-Au, Cu-Ni und Cu-Ni-Au ausgewählt ist.

8. Verfahren nach Anspruch 7, wobei die Nickelschichten jeweils eine Dicke im Bereich von 0,1 Mikrometer bis 50 Mikrometer aufweisen, die Kupferschichten jeweils eine Dicke im Bereich von 0,1 Mikrometer bis 100 Mikrometer aufweisen und die Goldschichten jeweils eine Dicke im Bereich von 0,01 Mikrometer bis 10 Mikrometer aufweisen.

9. Verfahren nach einem der vorhergehenden Ansprüche, wobei die Beschleunigerteilchen einen mittleren Durchmesser im Bereich von 20 Nanometer bis 100 Mikrometer aufweisen.

10. Verfahren nach einem der vorhergehenden Ansprüche, wobei die Menge der Beschleunigerteilchen 1 Gew.-% bis 40 Gew.-% des Gesamtgewichts des Kunststoffsubstrats beträgt.

11. Verfahren nach einem der vorhergehenden Ansprüche, wobei die Beschleunigerteilchen aus einer Verbindung hergestellt sind, die aus der Gruppe bestehend aus CuFe₂O_{3,65}, Ca_{0,25}Cu_{0,75}TiO_{2,84} und TiO ausgewählt ist.

12. Verfahren nach einem der vorhergehenden Ansprüche, wobei das Kunststoffmaterial aus der Gruppe bestehend aus einem Thermoplast und einem Duroplast ausgewählt ist.

13. Verfahren nach Anspruch 12, wobei der thermoplastische Kunststoff aus der Gruppe bestehend aus Polyolefin, Polycarbonat (PC), Polyester, Polyamid, polyaromatischem Ether, Polyesterimid, Polycarbonat-Acrylnitril-Butadien-Styrol-Gemisch (PC/ABS), Polyphenylenoxid (PPO), Polyphenylensulfid (PPS), Polyimid (PI), Polysulfon (PSU), Poly(etheretherketon) (PEEK), Polybenzimidazol (PBI), Flüssigkristallpolymer (LCP) und deren Kombinationen ausgewählt ist, und wobei das Duroplast aus der Gruppe bestehend aus Phenolharz, Harnstoff-Formaldehydharz, Melamin-Formaldehydharz, Epoxidharz, Alkydharz, Polyurethan und deren Kombinationen ausgewählt ist.

14. Kunststoffartikel, aufweisend:
ein Kunststoffsubstrat, das aus einem Kunststoffmaterial hergestellt ist, in dem eine Vielzahl von Beschleunigerteilchen dispergiert sind, wobei die Beschleunigerteilchen aus einer Verbindung hergestellt sind, die aus der Gruppe bestehend aus CuFe₂O_{4-δ}, Ca_{0,25}Cu_{0,75}TiO_{3-ß} und TiO_{2-σ} ausgewählt ist, wobei für δ, β, σ gilt: 0,05≤δ≤0,8, 0,05≤β≤0,5 und 0,05≤σ≤1,0; und
eine metallisierte Oberfläche, die unmittelbar auf dem Kunststoffsubstrat angeordnet ist und aus einer Vielzahl von Metallschichten zusammengesetzt ist.

15. Kunststoffsubstrat, das aus einem Kunststoffmaterial hergestellt ist, in dem eine Vielzahl von Beschleunigerteilchen dispergiert sind, wobei die Beschleunigerteilchen aus einer Verbindung hergestellt sind, die aus der Gruppe bestehend aus CuFe₂0_{4-δ}, Ca_{0,25}Cu_{0,75}TiO_{3-β} und TiO_{2-σ}, ausgewählt ist, wobei für δ, β, σ gilt: 0,05≤8≤0,8, 0,05≤β≤0,5 und 0,05≤σ≤1,0.

## Revendications

1. Procédé de fabrication d'un article plastique ayant une surface métallisée composée d'une pluralité de couches métalliques, comprenant les étapes suivantes :
prévoir un substrat plastique réalisé en une matière plastique, dans lequel est dispersée une pluralité de particules accélératrices, les particules accélératrices étant réalisées en un composé sélectionné dans le groupe constitué de CuFe₂O_{4-δ}, Ca_{0,25}Cu_{0,75}TiO_{3-ß}, et TiO_{2-σ}, où pour δ β, σ: 0,05≤δ≤0,8, 0,05≤ß≤0,5 et 0,05≤σ≤1,0 ;
enlever la matière plastique dans une zone déterminée d'une surface du substrat plastique ;
plaquer la surface exposée du substrat plastique pour former une première couche métallique ;
plaquer la première couche métallique pour former une deuxième couche métallique, et,
le cas échéant, plaquer ultérieurement d'autres couches métalliques.

2. Procédé selon la revendication 1, dans lequel l'accélérateur est distribué régulièrement sur l'ensemble du substrat plastique.

3. Procédé selon l'une quelconque des revendications précédentes, dans lequel la matière plastique dans la zone déterminée est enlevée par un procédé sélectionné dans un groupe constitué de rayonnement laser, décharge corona, corrosion chimique, et meulage.

4. Procédé selon l'une quelconque des revendications précédentes, dans lequel la deuxième couche métallique est plaquée par électrolyse ou plaquée de façon chimique.

5. Procédé selon l'une quelconque des revendications précédentes, dans lequel les couches métalliques sont réalisées en un métal sélectionné dans le groupe constitué de nickel, cuivre, et or.

6. Procédé selon la revendication 5, dans lequel la première couche métallique consiste en nickel ou cuivre.

7. Procédé selon la revendication 6, dans lequel la surface métallique de l'article plastique consiste en des couches métalliques plaquées séquentiellement qui ont une structure sélectionnée dans le groupe constitué de Ni-Cu-Ni, Ni-Cu-Ni-Au, Cu-Ni, et Cu-Ni-Au.

8. Procédé selon la revendication 7, dans lequel les couches de nickel ont une épaisseur comprise dans la plage entre 0,1 micromètres et 50 micromètres, les couches de cuivre ayant respectivement une épaisseur comprise dans la plage entre 0,1 micromètres et 100 micromètres, et les couches d'or ayant respectivement une épaisseur comprise dans la plage entre 0,01 micromètres et 10 micromètres.

9. Procédé selon l'une quelconque des revendications précédentes, dans lequel les particules accélératrices ont un diamètre moyen compris dans la plage entre 20 nanomètres et 100 micromètres.

10. Procédé selon l'une quelconque des revendications précédentes, dans lequel la quantité de particules accélératrices est de 1 % en poids à 40 % en poids du poids total du substrat plastique.

11. Procédé selon l'une quelconque des revendications précédentes, dans lequel les particules accélératrices sont réalisées en un composé sélectionné dans le groupe constitué de : CuFe₂O₃,₆₅, Ca_{0,25}Cu_{0,7}5TiO_{2,84} et TiO.

12. Procédé selon l'une quelconque des revendications précédentes, dans lequel la matière plastique est sélectionnée dans le groupe constitué d'un thermoplastique et d'une résine thermodurcissable.

13. Procédé selon la revendication 12, dans lequel le plastique thermoplastique est sélectionné dans le groupe constitué de polyoléfine, polycarbonate (PC), polyester, polyamide, éther polyaromatique, polyesterimide, un mélange de polycarbonate/acrylonitrile-butadiène-styrène (PC/ABS), poly(oxyde de phénylène) (PPO), poly(sulfure de phénylène) (PPS), polyimide (PI), polysulfone (PSU), polyétheréthercétone (PEEK), polybenzimidazole (PBI), polymère à cristaux liquides (LCP), et leurs combinaisons ; et dans lequel la résine thermodurcissable est sélectionnée dans le groupe constitué de résine phénolique, résine d'urée-formaldéhyde, résine mélamine-formaldéhyde, résine époxyde, résine alkyde, polyuréthane, et leurs combinaisons.

14. Article plastique, comprenant :
un substrat plastique réalisé en une matière plastique, dans lequel est dispersée une pluralité de particules accélératrices, les particules accélératrices étant réalisées en un composé sélectionné dans le groupe constitué de CuFe₂O_{4-δ}, Ca_{0,25}Cu_{0,75}TiO_{3-ß}, et TiO_{2-σ}, où pour δ ß, σ: 0,05≤δ≤0,8, 0,05≤ß≤0,5 et 0,05≤σ≤1,0 ; et
une surface métallique disposée directement sur le substrat plastique et étant composée d'une pluralité de couches métalliques.

15. Substrat plastique réalisé en une matière plastique, dans lequel est dispersée une pluralité de particules accélératrices, les particules accélératrices étant réalisées en un composé sélectionné dans le groupe constitué de CuFe₂O_{4-δ}, Ca_{0,25}Cu_{0,75}TiO_{3-ß}, et TiO_{2-σ}, où pour δ β, σ: 0,05≤δ≤0,8, 0,05≤ß≤0,5 et 0,05≤σ≤1,0.
